(19) Europäisches Patentamt / European Patent Office / Office européen des brevets

(11) **EP 2 756 599 B1**

(12) **EUROPÄISCHE PATENTSCHRIFT**

(45) Veröffentlichungstag und Bekanntmachung des Hinweises auf die Patenterteilung:
**24.02.2016 Patentblatt 2016/08**

(21) Anmeldenummer: **12743922.2**

(22) Anmeldetag: **17.07.2012**

(51) Int Cl.:
*G01N 27/00* (2006.01)    *G01V 9/00* (2006.01)
*H02M 5/42* (2006.01)    *H03M 1/00* (2006.01)
*G01S 15/93* (2006.01)    *G01S 7/529* (2006.01)
*G01S 13/93* (2006.01)    *H03M 1/18* (2006.01)

(86) Internationale Anmeldenummer:
**PCT/EP2012/063945**

(87) Internationale Veröffentlichungsnummer:
**WO 2013/037529 (21.03.2013 Gazette 2013/12)**

(54) **VERFAHREN ZUM VERSTÄRKEN EINES ZUR FAHRZEUGUMFELDDETEKTION GEEIGNETEN ECHOSIGNALS UND VORRICHTUNG ZUM DURCHFÜHREN DES VERFAHRENS**

METHOD FOR AMPLIFYING AN ECHO SIGNAL SUITABLE FOR OBSERVING THE ENVIRONMENT OF A VEHICLE AND APPARATUS FOR CARRYING OUT THE METHOD

PROCÉDÉ POUR AMPLIFIER UN SIGNAL D'ÉCHO ADAPTE POUR OBSERVATION DE L'ENVIRONNEMENT D'UN VÉHICULE ET DISPOSITIF POUR METTRE EN OEUVRE LA MÉTHODE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.09.2011 DE 102011082479**

(43) Veröffentlichungstag der Anmeldung:
**23.07.2014 Patentblatt 2014/30**

(73) Patentinhaber: **Robert Bosch GmbH**
**70442 Stuttgart (DE)**

(72) Erfinder: **KARL, Matthias**
**76275 Ettlingen (DE)**

(56) Entgegenhaltungen:
WO-A1-2010/076061    US-A1- 2005 280 568
US-A1- 2010 245 140

**Beschreibung**

Bereich der Erfindung

Die vorliegende Erfindung betrifft ein Verfahren zum Verstärken eines zur Fahrzeugumfelddetektion geeigneten Echosignals und eine geeignete Vorrichtung zum Durchführen des Verfahrens. Auch betrifft die Erfindung ein Fahrzeugassistenzsystem mit einer erfindungsgemäßen Vorrichtung zum Verstärken eines zur Fahrzeugumfelddetektion geeigneten Echosignals.

Stand der Technik

In der Schrift US 2010/245140 A1 werden zur Messung von Signalen mit sehr hohem Dynamikbereich schaltbare Verstärker mit fester Verstärkung verwendet.

Die Schrift US 2005/280568 A1 beschreibt eine Kombination von variabler Verstärkung und variabler Anpassung der Referenzspannung des A/D-Wandlers an das Empfangssignal für den Bereich der Telekommunikation.

Aus dem Dokument DE 10 2008 054 789 A1 ist ein Verfahren zum Verstärken eines zur Fahrzeugumfelddetektion geeigneten Echosignals bekannt, bei dem ein Verstärkungsfaktor abhängig von einer Laufzeit des Echosignals eingestellt wird. Hierzu ist ein variabler Verstärker vorgesehen, wobei die Verstärkungskurve auch einen sprunghaften Verlauf in mehreren Schritten aufweisen kann. Als Ausführungsbeispiel ist eine aufwändige Operationsverstärkerschaltung mit durch Zuschalten und Abschalten von Widerständen sprunghafter Verstärkungsumschaltung gezeigt. Es ist ebenfalls beschrieben, dass der Verlauf der sprunghaften Verstärkungsänderung durch eine zentrale Signalverarbeitung zusätzlich einkalibriert werden muss.

In demselben Dokument ist beschrieben, wie bei pulsweise messenden umfeldsensierenden Systemen der Auswerteaufwand mittels laufzeitabhängiger Verstärkung $V(\tau)$ reduziert werden kann, da mit zunehmender Echolaufzeit die Signalstärke kleiner wird. Es ist beschrieben, dass bevorzugt eine kontinuierliche Veränderung der Eingangsverstärkung vorgenommen wird, da das Empfangssignal durch eine kontinuierliche Veränderung im Vergleich zu einer sprunghaften Veränderung wesentlich geringer verfälscht wird.

Bei optimal ausgelegten Systemen sollte die Verstärkung $V(\tau)$ aus Systemsicht im Bereich von

$$1 \le \frac{V(\tau)}{V_0} < V_{max} \quad \text{mit} \quad V_{max} > 100 \quad \text{variiert werden}$$

können.

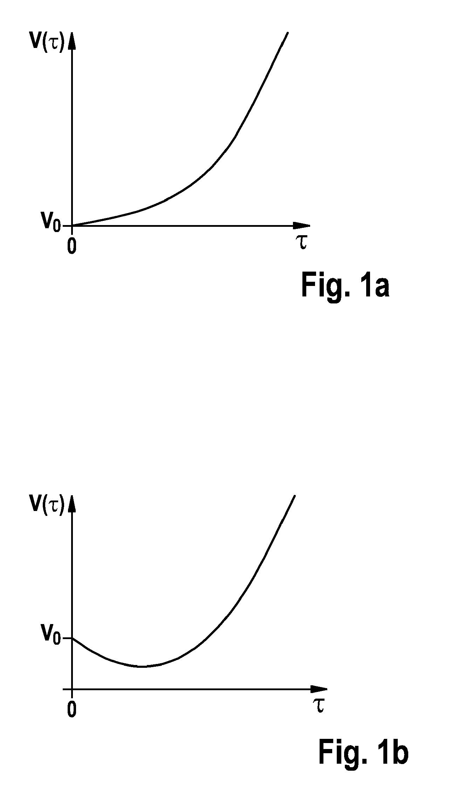

Die Figuren 1a und 1b zeigen beispielhaft zwei mögliche Verläufe einer gewünschten laufzeitabhängigen Signalverstärkung $V(\tau)$.

Aus dem Stand der Technik ist weiterhin bekannt, wie durch geeignete Beschaltung eines A/D-Wandlers vorzugsweise in einer Rekursionsschleife, die den Signalempfang, einen gewissen Teil der Signalauswertung sowie optional eine geeignete Erzeugung eines Steuersignals zur laufzeitabhängigen Verstärkungsregelung insbesondere eines A/D-Wandlers enthält, eine laufzeitabhängige Verstärkung mit geringem technischen Aufwand realisiert werden kann.

Die Rekursionsschleife ist für die Realisierung der laufzeitabhängigen Verstärkung nicht erforderlich. Wird sie verwendet, kann die laufzeitabhängige Verstärkung jedoch an die jeweilige Signalsituation angepasst werden, wodurch der benötigten Dynamikbereich des A/D-Wandlers verringert werden kann.

Die technische Realisierung von Verstärkern mit kontinuierlich einstellbarer Verstärkung ist jedoch sehr schwierig, zumal ja diese Verstärker neben dem einstellbaren Verstärkungsbereich noch einen geeigneten Dynamikbereich zur Verstärkung der eingehenden Signale besitzen sollen.

Die Realisierung von $N$ Verstärkern mit fester Verstärkung hingegen ist recht aufwandsarm realisierbar. Durch Reihenschaltung lässt sich mit solchen Verstärkern eine recht hohe Verstärkung

$$V_{\text{fest\_gesamt\_}N} = \prod_{j=1}^{N} V_{\text{fest } j} \quad \text{realisieren und an}$$

den Übergängen zwischen den Verstärkern liegt das Signal jeweils teilverstärkt vor:

$$V_{\text{fest\_gesamt } k} = \prod_{j=1}^{k} V_{\text{fest } j} \; .$$

Äquivalentes gilt für A/D-Wandler. Der Bereich, in dem die Referenzspannung von A/D-Wandlern ohne negative Rückwirkungen auf die Güte der A/D-Wandlung variiert werden können, liegt typische Weise nur im Bereich 1 bis 4.

Daher gibt es weder preiswerte A/D-Wandler noch preiswerte variabel einstellbare Verstärker mit denen der geforderte variable Verstärkungsbereich

$$1 \le \frac{V(\tau)}{V_0} < V_{max} \quad \text{bei ca. 50kHz realisiert werden kann.}$$

Offenbarung der Erfindung

Es wird ein Verfahren und eine Vorrichtung gemäß den beigefügten unabhängigen Ansprüchen bereitgestellt.

Bei dem erfindungsgemäßen Verfahren zum Verstärken eines Echosignals wird ein analoges, zur Fahrzeugumfelddetektion geeignetes Echosignal mit einem von der Laufzeit des Echosignals abhängigen Verstärkung verstärkt. Das analoge Echosignal wird mittels eines Verstärkers mit einer Vielzahl von Ausgängen mit jeweils unterschiedlicher insbesondere fester Verstärkung und eines nachgeschalteten A/D-Wandlers mit einer zeitvariablen Referenzspannung verstärkt. Dabei wird zwischen unterschiedlichen Ausgängen des Verstärkers zu vordefinierten Umschaltzeitpunkten umgeschaltet und die Referenzspannung des A/D-Wandlers zwischen den Umschaltzeitpunkten zeitlich derart variiert, dass am Ausgang des A/D-Wandlers das Echosignal mit einer laufzeitabhängigen Gesamtverstärkung vorliegt, die einen vorgegebenen Verlauf aufweist.

Die erfindungsgemäße Vorrichtung zum laufzeitabhängigen Verstärken mindestens eines zur Fahrzeugumfelddetektion geeigneten Echosignals umfasst einen Verstärker mit einer Vielzahl von Ausgängen mit jeweils unterschiedlicher insbesondere fester Verstärkung, einen nachgeschalteten A/D-Wandler mit zeitvariablen Referenzspannung und eine Steuervorrichtung, die dazu ausgebildet ist, zwischen unterschiedlichen Ausgängen des Verstärkers zu vordefinierten Umschaltzeitpunkten umzuschalten und eine zeitabhängige, am Ausgang des A/D-Wandlers vorliegende Gesamtverstärkung des Echosignals mit einem vorgegebenen Verlauf mittels einer geeigneten, zwischen den Umschaltzeitpunkten durchgeführten Variation der Referenzspannung des A/D-Wandlers zu generieren.

Die Unteransprüche zeigen bevorzugte Weiterbildungen der Erfindung.

Durch eine geeignete Variation der Referenzspannung des A/D-Wandlers zwischen den Umschaltzeitpunkten wird aus der von dem Verstärker zwischen den Umschaltzeitpunkten generierten Teilverstärkung des Echosignals in einer einfachen und aufwandsarmen Weise eine laufzeitabhängige Gesamtverstärkung des Echosignals mit einem gewünschten Verlauf generiert.

Durch die geeignete Variation der Referenzspannung des A/D-Wandlers wird der Gesamtdynamikbereich des analogen Echosignals in einfacher Weise auf einen kleineren effektiven Gesamtdynamikbereich abgebildet, was zu eine Reduzierung des bei der Auswertung des Echosignals benötigten Rechenaufwands führt.

Das erfindungsgemäße Verfahren ermöglicht auch die Verwendung eines kostengünstigen A/D-Wandlers, dessen Referenzspannung nur in einem geringen Bereich variiert werden muss.

In einem besonders vorteilhaften Ausführungsbeispiel der Erfindung wird das analoge Echosignal mittels einer in Reihe geschaltete Kette von Verstärkern insbesondere fester Verstärkung und des nachgeschalteten A/D-Wandlers mit der zeitvariablen Referenzspannung verstärkt.

Die Realisierung eines Verstärkers mit $N$ in Reihe geschalteten Verstärkern mit fester Verstärkung ist gegenüber der Realisierung eines Verstärkers mit kontinuierlich einstellbarer Verstärkung recht kostengünstig und aufwandsarm realisierbar. Durch die Reihenschaltung der Verstärker lässt sich eine recht hohe Verstärkung $V_{\text{fest\_gesamt\_}N} = \prod\limits_{j=1}^{N} V_{\text{fest}\ j}$ realisieren.

An den Übergängen zwischen den in Reihe geschalteten Verstärkern liegt ein teilverstärktes Signal vor, das eine Teilverstärkung von

$$V_{\text{fest\_gesamt}\ k} = \prod\limits_{j=1}^{k} V_{\text{fest}\ j}$$ aufweist.

Nach der Erfindung ist der Verlauf der Gesamtverstärkung insbesondere stückweise zwischen den Umschaltzeitpunkten vorgegeben.

Ferner wird erfindungsgemäß ein aufwandarmes Verfahren zur Fahrzeugumfelddetektion mittels mindestens eines Echosignals bereitgestellt, bei dem mindestens ein analoges Echosignal mittels eines erfindungsgemäßen Verfahrens verstärkt wird und zumindest das verstärkte Echosignal zur Fahrzeugumfelddetektion ausgewertet wird.

Weiterhin wird erfindungsgemäß ein kostengünstiges Fahrzeugassistenzsystem zur Fahrzeugumfelddetektion mit einer erfindungsgemäßen Vorrichtung zum Verstärken mindestens eines zur Fahrzeugumfelddetektion geeigneten Echosignals bereitgestellt, das eine Auswerteeinheit zur Fahrzeugumfelddetektion zumindest durch ein mittels der erfindungsgemäßen Vorrichtung verstärktes und/oder nicht verstärktes Echosignal umfasst.

Zeichnung

Nachfolgend werden Ausführungsbeispiele der Erfindung unter Bezugnahme auf die begleitende Zeichnung im Detail beschrieben. In der Zeichnung ist:

Figur 1a und 1b    jeweils einen möglichen Verlauf einer laufzeitabhängigen Signalverstärkung nach dem Stand der Technik,

Figur 2    eine erfindungsgemäße Vorrichtung zur Erzeugung einer laufzeitabhängigen Signalverstärkung nach der ersten Ausführungsform der Erfindung, und

Figur 3    einen möglichen Verlauf der laufzeitabhängigen Signalverstärkung nach der ersten Ausführungsform der Erfindung.

Ausführungsformen der Erfindung

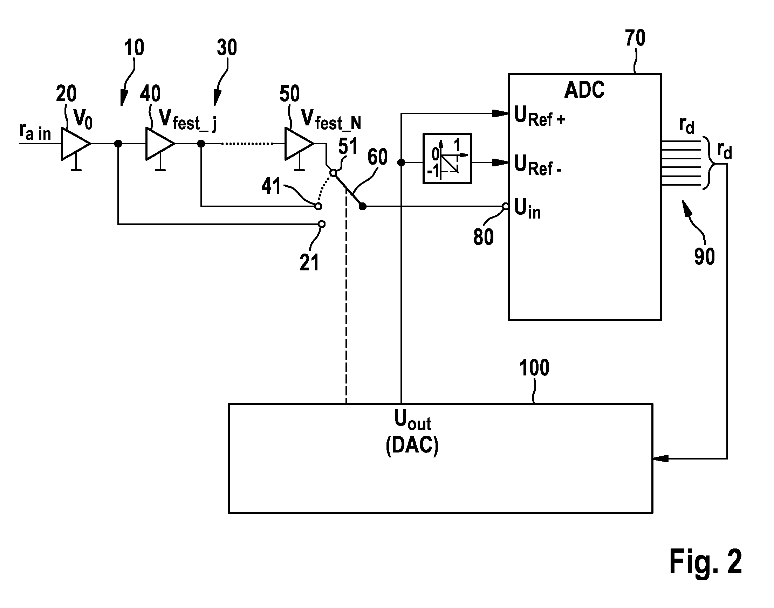

In der Figur 2 ist eine erfindungsgemäße Vorrichtung 10 zur Erzeugung einer laufzeitabhängigen Signalverstärkung $V(\tau)$ nach der ersten Ausführungsform der Erfindung dargestellt.

Das analoge, von der Laufzeit $\tau$ des Echos abhängigen Eingangssignal (Echosignal) $r_{a\ in}$ mit einer üblichen Mittenfrequenz von insbesondere circa 48 kHz erfährt mittels eines Grundverstärkers 20 eine Grundverstärkung $V_0$. Ein nachgeschalteter Verstärker 30 umfasst $N$ seriell geschaltete, miteinander kaskadierte Verstärker 40, 50 mit fester Verstärkung $V_{\text{fest}\ j}$, die zu einer festen Gesamtverstärkung des Eingangssignals

$$V_{\text{fest\_gesamt}\ N} = \prod_{j=1}^{N} V_{\text{fest}\ j}$$ führen.

In der Figur 2 sind von den $N$ seriell geschalteten Verstärkern 40, 50 nur zwei dargestellt.

Mittels mindestens eines Analogschalters 60 wird zwischen den Umschaltzeitpunkten $\tau_k$, $\tau_{k+1}$ jeweils eine feste Verstärkung $V_{\text{fest\_gesamt}\ k}$ ausgewählt und das derart verstärkte Analogsignal auf einen nachgeschalteten A/D-Wandler (ADC) 70 gegeben. Dabei steuert die Steuervorrichtung 100 den mindestens einen Analogschalter 60 derart, dass die $N$ Ausgänge 41, 51 des Verstärkers 30 nacheinander zu vordefinierten Umschaltzeitpunkten $\tau_1$, ..., $\tau_N$ jeweils mit dem Eingang 80 des A/D-Wandlers verbunden werden.

Durch Variation der Referenzspannung des A/D-Wandlers $U_{\text{Ref}}\ \text{AD}^{(\tau)}|_{\tau_k \leq \tau < \tau_{k+1}}$ mittels der Steuervorrichtung 100 wird eine entsprechende zeitvariante Verstärkung $v_{\text{AD}}^{(\tau)}|_{\tau_k \leq \tau < \tau_{k+1}}$ derart erzeugt, dass sich die Gesamtsystemverstärkung der abgetasteten Signale entsprechend einem vorgegebenen Verlauf $V(\tau)$ verhält. Am Ausgang 90 des A/D-Wandlers 70 liegt ein mit der Gesamtsystemverstärkung verstärktes Ausgangssignal $r_d$ vor.

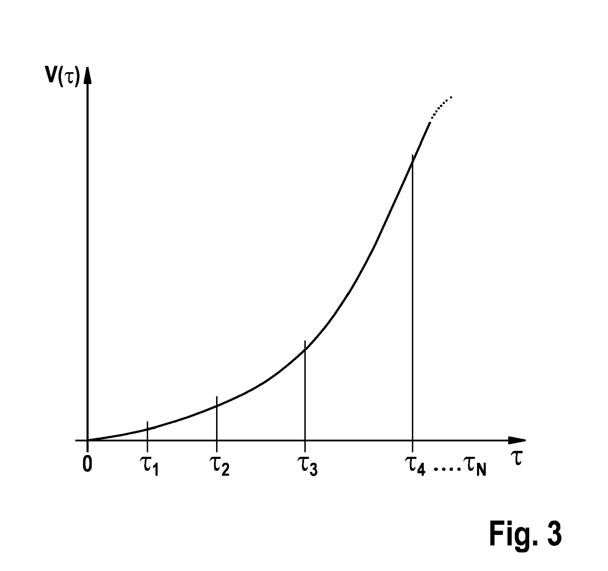

Die Variation der Referenzspannung $U_{\text{Ref}}$ $\text{AD}^{(\tau)}|_{\tau_k \leq \tau \leq \tau_{k+1}}$ des A/D-Wandlers 70 wirkt sich für das Gesamtsystem wie eine zeitvariante Verstärkung $v_{\text{AD}}^{(\tau)}|_{\tau_k \leq \tau \leq \tau_{k+1}}$ abgetasteten Signale aus. Der gewünschte Verstärkungsverlauf $V(\tau)$ kann, wie in der Figur 3 dargestellt, stückweise zwischen den Umschaltzeitpunkten $0$, $\tau_1$, $\tau_2$, $\tau_3$, $\tau_4$,..., $\tau_N$ generiert werden.

Erfindungsgemäß wird insbesondere eine kostengünstige Vorrichtung 10 mit einer Architektur bereitgestellt, mit der die Funktion einer gewünschten, kontinuierlich einstellbaren Verstärkung im geforderten Dynamikbereich $1 \leq \dfrac{V(\tau)}{V_0} < V_{\max}$ in einfacher Weise realisiert werden kann.

Mittels der erfindungsgemäße Vorrichtung 10 zur Verstärkung und anschließenden Analog-Digitalwandlung von Signalen $r_{a\ in}$ wird insbesondere eine laufzeitabhängige Verstärkung $V(\tau)$ mittels einer in Reihe geschalteten Kette von Verstärkern 40, 50 fester Verstärkung $V_{\text{fest}\ j}$ realisiert, bei der zu gewissen Zeitpunkten $\tau_1$, $\tau_2$, ..., $\tau_N$ mittels mindestens eines Analogsignalschalters 60 zwischen unterschiedlichen wirksamen festen Teilverstärkungen $V_{\text{fest\_gesamt}\ k}$ umgeschaltet wird und die nachgelagerte A/D-Wandlung 70 mittels zeitvariabler Referenzspannung $U_{\text{Ref}}\ \text{AD}(\tau)|_{\tau_k \leq \tau \leq \tau_{k+1}}$ jeweils zwischen den Umschaltzeitpunkten $\tau_k$, $\tau_{k+1}$ derart beeinflusst wird, dass die Gesamtsystemverstärkung durch diese sukzessive Approximation quasi gleich der gewünschten laufzeitabhängigen Verstärkung $V(\tau)$ ist.

Neben der voranstehenden schriftlichen Offenbarung wird hiermit zur weiteren Offenbarung der Erfindung ergänzend ausdrücklich auf die Darstellung in den Figuren 2 und 3 Bezug genommen.

**Patentansprüche**

1. Verfahren zum Verstärken eines Echosignals, bei dem ein analoges, zur Fahrzeugumfelddetektion geeignetes Echosignal ($r_{a\ in}$) mit einem von der Laufzeit des Echosignals ($r_{a\ in}$) abhängigen Verstärkung verstärkt wird, **dadurch gekennzeichnet, dass** das analoge Echosignal ($r_{a\ in}$) mittels eines Verstärkers (30) mit einer Vielzahl (N) von Ausgängen (41, 51) mit jeweils unterschiedlicher Verstärkung ($V_{\text{fest\_gesamt}\ k}$) und eines nachgeschalteten A/D-Wandlers (70) mit einer zeitvariablen Referenzspannung ($U_{\text{Ref}}$) verstärkt wird, wobei zwischen unterschiedlichen Ausgängen (41, 51) des Verstärkers (30) zu vordefinierten Umschaltzeitpunkten ($\tau_1$,..., $\tau_N$) umgeschaltet wird und die Referenzspannung ($U_{\text{Ref}}$) des A/D-Wandlers (70) zwischen den Umschaltzeitpunkten ($\tau_k$, $\tau_{k+1}$) zeitlich derart variiert wird, dass am Ausgang (90) des A/D-Wandlers (70) das Echosignal ($r_d$) mit einer laufzeitabhängigen Gesamtverstärkung, die einen vorgegebenen Verlauf ($V(\tau)$) aufweist, vorliegt.

2. Verfahren nach Anspruch 1, **dadurch gekennzeichnet, dass** das analoge Echosignal ($r_{a\ in}$) mittels einer in Reihe geschaltete Ketten von Verstärkern (40, 50) insbesondere fester Verstärkung ($V_{\text{fest}\ j}$) und des nachgeschalteten A/D-Wandlers (70) mit der zeitvariablen Referenzspannung ($U_{\text{Ref}}$) verstärkt wird.

3. Verfahren nach Anspruch 1 oder 2, **dadurch gekennzeichnet, dass** der Verlauf stückweise zwischen den Umschaltzeitpunkten ($\tau_k$, $\tau_{k+1}$) vorgegeben ist.

4. Verfahren zur Fahrzeugumfelddetektion mittels mindestens eines Echosignals, bei dem mindestens ein analoges Echosignal ($r_{a\ in}$) mittels eines Verfahrens nach einem der vorangehenden Ansprüche verstärkt wird und zumindest das verstärkte Echosignal ($r_d$) zur Fahrzeugumfelddetektion ausgewertet wird.

5. Vorrichtung (10) zum Verstärken mindestens eines zur Fahrzeugumfelddetektion geeigneten Echosignals, die einen Verstärker (30) zum Verstärken eines analogen Echosignals ($r_{a\ in}$) mit einer zeitabhängigen Verstärkung aufweist, **gekennzeichnet durch** einen Verstärker (30) mit einer Vielzahl (N) von Ausgängen (41, 51) mit unterschiedlichen Verstärkungen ($V_{fest\_gesamt\ k}$), einen nachgeschalteten A/D-Wandlers (70) mit zeitvariablen Referenzspannung ($U_{Ref}$) und eine Steuervorrichtung (100), die dazu ausgebildet ist, zwischen unterschiedlichen Ausgängen (41, 51) des Verstärkers (30) zu vordefinierten Umschaltzeitpunkten ($\tau_1,..., \tau_N$) umzuschalten und eine zeitabhängige, am Ausgang des A/D-Wandlers (70) vorliegende Gesamtverstärkung des Echosignals ($r_d$) mit einem vorgegebenen Verlauf ($V(\tau)$) mittels einer geeigneten, zwischen den Umschaltzeitpunkten ($\tau_k$, $\tau_{k+1}$) durchgeführten Variation der Referenzspannung ($U_{Ref}$) des A/D-Wandlers (70) zu generieren.

6. Vorrichtung (10) nach Anspruch 5 **dadurch gekennzeichnet, dass** die Steuervorrichtung (100) dazu ausgebildet ist, mindestens einen Eingang (80) des A/D-Wandlers (70) mit mehreren, insbesondere mit allen Ausgängen (41, 51) des Verstärkers (20) nacheinander zu den vordefinierten Umschaltzeitpunkten ($\tau_1,..., \tau_N$) mittels mindestens eines Analogschalters (60) zu verbinden.

7. Vorrichtung (10) nach einem der Ansprüche 5 oder 6 **dadurch gekennzeichnet, dass** der Verstärker (30) eine in Reihe geschaltete Kette von Verstärkern (40, 50) insbesondere fester Verstärkung ($V_{fest\ j}$) umfasst.

8. Vorrichtung (10) nach einem der Ansprüche 5 bis 7, **dadurch gekennzeichnet, dass** der Verlauf stückweise zwischen den Umschaltzeitpunkten ($\tau_k$, $\tau_{k+1}$) vorgegeben ist.

9. Fahrzeugassistenzsystem zur Fahrzeugumfelddetektion mit einer Vorrichtung (10) nach einem der Ansprüche 5 bis 8, **gekennzeichnet durch** eine Auswerteeinheit zur Fahrzeugumfelddetektion zumindest **durch** ein mittels der Vorrichtung (10) nach einem der Ansprüche 5 bis 8 verstärktes Echosignal ($r_d$) und/oder nicht verstärktes Echosignal ($r_{a\ in}$).

**Claims**

1. Method for amplifying an echo signal, in which an analogue echo signal (rain) that is suitable for vehicle environment detection is amplified using a gain that is dependent on the delay of the echo signal ($r_{a\ in}$), **characterized in that** the analogue echo signal ($r_{a\ in}$) is amplified by means of an amplifier (30) having a multiplicity (N) of outputs (41, 51) that each have different gain ($V_{fixed\_total\ k}$) and by means of a downstream A/D converter (70) having a time-variable reference voltage ($U_{Ref}$), wherein the amplifier (30) is changed over between different outputs (41, 51) at predefined changeover time(s) ($\tau_1..., \tau_N$) and the reference voltage ($U_{Ref}$) of the A/D converter (70) is varied in respect of time between the changeover time (s) ($\tau_k$, $\tau_{k+1}$) such that the output (90) of the A/D converter (70) produces the echo signal ($r_d$) with a delay-dependent total gain that has a prescribed profile ($V(\tau)$).

2. Method according to Claim 1, **characterized in that** the analogue echo signal ($r_{a\ in}$) is amplified by means of a series-connected chain of amplifiers (40, 50), particularly of fixed gain ($V_{fixed\ j}$), and the downstream A/D converter (70) having the time-variable reference voltage ($U_{Ref}$).

3. Method according to Claim 1 or 2, **characterized in that** the profile is prescribed on a piece-by-piece basis between the changeover time(s) ($\tau_k$, $\tau_{k+1}$).

4. Method for vehicle environment detection by means of at least one echo signal, in which at least one analogue echo signal ($r_{a\ in}$) is amplified by means of a method according to one of the preceding claims and at least the amplified echo signal ($r_d$) is evaluated for the purpose of vehicle environment detection.

5. Apparatus (10) for amplifying at least one echo signal that is suitable for vehicle environment detection, which apparatus has an amplifier (30) for amplifying an analogue echo signal ($r_{a\ in}$) using a time-dependent gain, **characterized by** an amplifier (30) having a multiplicity (N) of outputs (41, 51) having different gains ($V_{fixed\_total\ k}$), a downstream A/D converter (70) having a time-variable reference voltage ($U_{Ref}$) and a control apparatus (100) that is designed to change over between different outputs (41, 51) of the amplifier (30) at predefined changeover time (s) ($\tau_1,..., \tau_N$) and to generate a time-dependent total gain, which is present at the output of the A/D converter (70), for the echo signal ($r_d$) having a prescribed profile ($V(\tau)$) by means of suitable variation of the reference voltage ($U_{Ref}$) of the A/D converter (70), which variation is performed between the changeover time(s) ($\tau_k$, $\tau_{k+1}$).

6. Apparatus (10) according to Claim 5, **characterized in that** the control apparatus (100) is designed to connect at least one input (80) of the A/D converter (70) to a plurality of, particularly to all, outputs (41, 51) of the amplifier (20) in succession at the predefined changeover time(s) ($\tau_1,..., \tau_N$) by means of at least one analogue switch (60).

7. Apparatus (10) according to either of Claims 5 and 6, **characterized in that** the amplifier (30) comprises a series-connected chain of amplifiers (40, 50), particularly of fixed gain ($V_{fixed\ j}$).

8. Apparatus (10) according to one of Claims 5 to 7, **characterized in that** the profile is prescribed on a piece-by-piece basis between the changeover time(s) ($\tau_k$, $\tau_{k+1}$).

9. Vehicle assistance system for vehicle environment detection having an apparatus (10) as claimed in one of Claims 5 to 8, **characterized by** an evaluation unit for vehicle environment detection at least by an echo signal ($r_d$) that is amplified by means of the apparatus (10) according to one of Claims 5 to 8 and/or by an unamplified echo signal ($r_{a\ in}$).

## Revendications

1. Procédé pour amplifier un signal d'écho, dans lequel un signal d'écho analogique ($r_{a\ in}$) approprié pour la détection de l'environnement d'un véhicule est amplifié avec un facteur d'amplification dépendant du temps de propagation du signal d'écho ($r_{a\ in}$), **caractérisé en ce que** le signal d'écho analogique ($r_{a\ in}$) est amplifié au moyen d'un amplificateur (30) comportant une pluralité (N) de sorties (41, 51) ayant des facteurs d'amplification ($V_{fest\_gesamt\ k}$) respectifs différents et d'un convertisseur A/N (70) connecté en aval et ayant une tension de référence variable dans le temps ($U_{Ref}$), dans lequel un basculement est effectué entre des sorties différentes (41, 51) de l'amplificateur (30) à des instants de basculement prédéfinis ($\tau_1$,..., $\tau_N$) et la tension de référence ($U_{Ref}$) du convertisseur A/N (70) est amenée à varier dans le temps entre les instants de basculement ($\tau_k$, $\tau_{k+1}$) de manière à ce que le signal d'écho ($r_d$) soit présent à la sortie (90) du convertisseur A/N (70) avec un facteur d'amplification global dépendant du temps de propagation, lequel facteur présente une évolution prédéterminée ($V(\tau)$).

2. Procédé selon la revendication 1, **caractérisé en ce que** le signal d'écho analogique ($r_{a\ in}$) est amplifié au moyen d'une chaîne connectée en série d'amplificateurs (40, 50) ayant un notamment un facteur d'amplification fixe ($V_{fest\ j}$) et du convertisseur A/N (70) connecté en aval et ayant la tension de référence variable dans le temps ($U_{Ref}$).

3. Procédé selon la revendication 1 ou 2, **caractérisé en ce que** l'évolution est prédéterminée par morceaux entre des instants de basculement ($\tau_k$, $\tau_{k+1}$).

4. Procédé pour détecter l'environnement d'un véhicule au moyen d'au moins un signal d'écho, dans lequel au moins un signal d'écho analogique ($r_{a\ in}$) est amplifié au moyen d'un procédé selon l'une quelconque des revendications précédentes et au moins le signal d'écho amplifié ($r_d$) est évalué pour la détection de l'environnement du véhicule.

5. Dispositif (10) pour amplifier au moins un signal d'écho approprié pour la détection de l'environnement d'un véhicule, qui comprend un amplificateur (30) destiné à amplifier un signal d'écho analogique ($r_{a\ in}$) avec un facteur d'amplification dépendant du temps, **caractérisé par** un amplificateur (30) comportant une pluralité (N) de sorties (41, 51) ayant des facteurs d'amplification ($V_{fest\_gesamt\ k}$) différents, un convertisseur A/N (70) connecté en aval et ayant une tension de référence variable dans le temps ($U_{Ref}$) et un dispositif de commande (100) qui est conçu pour effectuer un basculement entre des sorties différentes (41, 51) de l'amplificateur (30) à des instants de basculement prédéfinis ($\tau_1$, ..., $\tau_N$) et pour générer un facteur d'amplification du signal d'écho ($r_d$) dépendant du temps présent à la sortie du convertisseur A/N (70) ayant une évolution prédéterminée ($V(\tau)$) au moyen d'une modification appropriée effectuée entre les instants de basculement ($\tau_k$, $\tau_{k+1}$) de la tension de référence ($U_{Ref}$) du convertisseur A/N (70).

6. Dispositif (10) selon la revendication 5, **caractérisé en ce que** le dispositif de commande (100) est conçu pour connecter successivement au moins une entrée (80) du convertisseur A/N (70) à une pluralité, notamment à la totalité des sorties (41, 51) de l'amplificateur (20) à des instants de basculement prédéfinis ($\tau_1$,..., $\tau_N$) au moyen d'au moins un commutateur analogique (60).

7. Dispositif (10) selon l'une quelconque des revendications 5 ou 6, **caractérisé en ce que** l'amplificateur (30) comprend une chaîne connectée en série d'amplificateurs (40, 50) ayant notamment un facteur d'amplification fixe ($V_{fest\ j}$).

8. Dispositif (10) selon l'une quelconque des revendications 5 à 7, **caractérisé en ce que** l'évolution est prédéterminée par morceaux entre les instants de basculement ($\tau_k$, $\tau_{k+1}$).

9. Système d'assistance à la conduite destiné à détecter l'environnement d'un véhicule, comportant un dispositif (10) selon l'une quelconque des revendications 5 à 8, **caractérisé par** une unité d'évaluation destinée à détecter l'environnement du véhicule à l'aide d'un signal d'écho ($r_d$) amplifié au moyen du dispositif (10) selon l'une quelconque des revendications 5 à 8 et/ou du signal d'écho (rain) non amplifié.

Fig. 1a

Fig. 1b

Fig. 2

EP 2 756 599 B1

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2010245140 A1
- US 2005280568 A1
- DE 102008054789 A1